# EUROPEAN PATENT SPECIFICATION

(11) **EP 3 236 315 B1**
(45) Date of publication and mention of the grant of the patent: **31.01.2024**
(21) Application number: 15869145.1
(22) Date of filing: 13.11.2015
(51) Int. Cl.: G03F 7/004, G03F 7/09, G03F 7/095, B41C 1/10

(54) **POSITIVE IMAGE PS PLATE AND CTCP LITHOGRAPHIC PRINTING PLATE PLATE MATERIAL**
PLATTENMATERIAL FÜR POSITIVBILD-PS-PLATTEN UND CTCP-FLACHDRUCKPLATTEN
PLAQUE PS D'IMAGE POSITIVE ET MATÉRIAU DE PLAQUE POUR PLAQUE D'IMPRESSION LITHOGRAPHIQUE CTCP

(30) Priority: 15.12.2014 CN 201410776580
(43) Date of publication of application: 25.10.2017
(73) Proprietor: Qingdao Lanfan Advanced Materials Co. Ltd., Qingdao, Shandong 266000 (CN)
(72) Inventor: LIU, Yang, Qingdao Shandong 266000 (CN)
(74) Representative: Tahtadjiev, Konstantin
(86) International application number: PCT/CN2015/094577
(87) International publication number: WO 2016/095636

(56) References cited:
- EP-A1- 2 293 144
- EP-A1- 2 365 389
- CN-A- 102 504 137
- CN-A- 103 848 930
- CN-A- 104 503 204
- JP-A- H0 798 500
- JP-A- H09 319 077

## Description

### BACKGROUND OF THE PRESENT INVENTION

### FIELD OF INVENTION

The present invention relates to field of printing plate, and more particularly to a kind of printing plate material for positive-image PS plate and CTcP lithographic plate used in lithographic printing.

### DESCRIPTION OF RELATED ARTS

Since Kalle company of Germany invented diazo naphthoquinone positive-image PS plate W system in 1930s, 80 years has gone. The system has been basic system of commercialized positive-image PS plate. Diazo naphthoquinone sulfonate was used as the photosensitive compound. Novolacs resin is used as a film-forming resin. The photosensitive compound and the film-forming resin W are mixed according to a predetermined proportion. A predetermined amount of background coloring dye is added, then the positive-image PS plate photosensitive solution is formed after being deployed with glycol monoalkyl ether or other solvent. The positive-image PS plate photosensitive solution is coated on an aluminium plate base having the hydrophilic graining structure, which is dried to obtain pre-sensitized version PS plate. The diazo photosensitive compound naphthoquinone sulfonate of the plate photosensitive layer was sensitive to ultraviolet light, which encountered diazo decomposition while meeting UV irradiation. The o-quinone azide is translated into the indanone and then is translated into the indan-acid. Thus, when the alkaline developing solution is used, the portions, which are exposed to the light, of the plate are dissolved and removed to expose the hydrophilic aluminium plate base, so as to show hydrophily, so as to become hydrophilic non-image portion when printing; and for the unexposed portions, the intermolecular association between the o-quinone azide and the phenolic hydroxyl group of the film-forming phenolic hydroxyl resin occurrs to form a stable six-ring structure, so as to increase the alkali-insoluble of the coating, so that within the developing time, none or less of the unexposed portions will be dissolved in the alkaline developer, so the unexposed portions of the plate remain on the aluminium plate base and become lipophilic graphic part when printing is worked.

With the development of computer, laser and information technology, in addition to the CTP technology using principle of thermo imaging plate, the CTcP technology, according to which, the traditional positive-image PS plate being used in computer-to-plate technology has also been developed rapidly. This technology applies high pressure mercury lamp and/or 405nm UV laser light source to print plate by computer directly. To improve the quality and efficiency of the plate printing, the sensitivity, resolution, pressrun and other requirements to the plate is higher. For the traditional PS plate, to adapt to the requirements of the laser platemaking, to meet the requirements of sensitivity is the most critical factor. To meet the challenges of CTP technology, the major companies have made much research in improving the sensitivity of the positive-image PS plate. As JP2005352004, JP2003043683. There are much more patent according to which, the sensitivity and resolution are both improved, for example JP200319 5501, JP2001138652, JP2001066773, JP9319077, US6010820, etc.. The above-mentioned patent enable computer-to-plate by adjusting the ratio of the photosensitive resin, adding acrylic copolymers with carboxyl group or fluorine, adding developing accelerators, such as m-cresol resin, anhydride, applying dual coating structure, and using the chemical growth (acid proliferation) mechanism or other methods to improve the sensitivity of the plate.

EP2293144 A and EP2365389 A disclose a printing plate comprising in this order a hydrophilic layer, a bottom layer and an upper layer.

However, according to the photosensitive imaging principle of the conventional PS plate, the requirement of the sensitivity and the alkali-insoluble is different. For exposed portions of the coating, it is better that after being exposed in a short time, the exposed portions of the coating can be completely dissolved in the developer. For the unexposed portions of the coating, it is better that there is loss as little as possible. This holding of the equilibrium is limited. Whether for the conventional PS plate or the CTcP plate, there is the problem of poor chemical resistance, which refers to low pressrun, poor resistance to chemical cleaning agents, intolerance UV ink, etc.. To improve the above-mentioned properties, the baking plate operating is generally taken. The baking plate operating has some problems, such as needing high-temperature baking, hard to retouch, poor precision, et al.. With the state increasingly stringent environmental requirements, the emissions of VOC from a printing house has been given strict control gradually. UV curable ink without VOC Emissions continues to develop. In addition to the advantage of none VOC is discharged, the UV curable ink also has the advantage of having bright color, good flexibility, being adapted to heat-sensitive substrates, etc.. Thus, it is more and more important to increase the solvent-resistance ability of the plate.

### SUMMARY OF THE PRESENT INVENTION

The invention is advantageous in that it improves chemical resistance of the positive-image PS plate and the CTcP plate, and increases the sensitivity, resolution and pressrun of the plate, so that the plate is suitable to UV ink printing.

In order to solve the above technical problems, the technical solutions of the present invention are as follows:

A printing plate material for positive-image PS plate and CTcP lithographic printing plate according to the present invention, which comprises a hydrophilic layer. The hydrophilic layer is coated with a bottom layer consisting of some photosensitive composition. The bottom layer is coated with a top layer consisting of some photosensitive composition. The weight of the top layer is 0.2∼1.0g/m². The weight of the photosensitive coating is 0.5~1.5g/m². The bottom layer and the top is sensitive to the visible light and the UV, which is alkali-soluble after being exposed. After being exposed to the visible light and/or the UV, the plate material is treated by the alkaline solution to develop, so that the exposed regions are dissolved and are cleared, wherein the non-exposed regions are reserved for being insoluble or minor erosion. The bottom layer comprises a positive-image photosensitive layer. The photosensitive layer consists essentially of chemical resistant functional resin, photoactive compound, development accelerators and background coloring dye.

The bottom chemical resistant functional resin is a copolymer being represented by Formula I. Branch chain carbon atom of the copolymer is provided with one or more group selected from the group consisting of the benzyl sulfonyl amino acrylic amide units and the N-aryl maleimide units. The molecular weight of the copolymer ranges from 1000~100000. The mass fraction of the benzyl sulfonyl amino acrylic amide in the copolymer is 5%~70%. The mass fraction of the N-aryl maleimide in the copolymer is 5%~70%. The percentage composition of the chemical-resistant functional resin in the bottom photosensitive composition is 75∼85%.

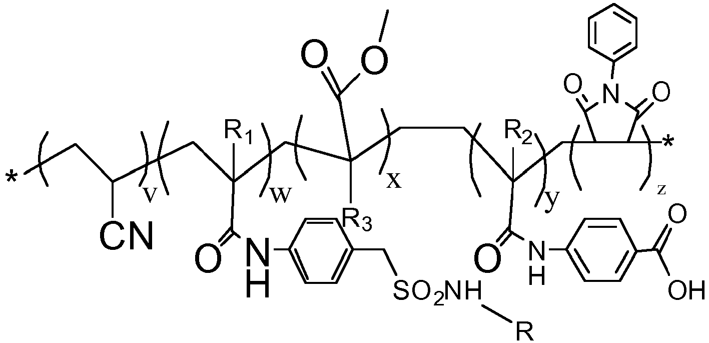

wherein R is selected from the group consisting of H, C₁~C₄ alkyl groups and aryl groups, wherein R₁, R₂ and R₃ represent H or CH₃, wherein v, w, x, y, z respectively represent the monomer components of the copolymer molecules, the mass fraction of which range from 5% to 70%. The sum of the monomer represented by v, w, x, y and z is 100%.

Furthermore, the bottom photosensitive compound is 1,2-naphthoquinone-2 diazo-4-sulphonate compound or 1,2-naphthoquinone-2-diazo-5-sulphonate compound. The esterification parent of the sulphonate compound are selected from the group consisting of the low-molecular-weight polyphenol compound, the pyrogallol-acetone condensation polymers and the linear phenolic resins. The weight average molecular weight of the esterification parent is 50~20000. Mw/Mn is 1.5~20. The esterification rate of the hydroxy is 10%~80%. The mass fraction of the photosensitive compound in the bottom photosensitive layer is 2%~20%. Furthermore, the development accelerator of the bottom layer is a mixture comprises carboxylic acid, carboxylic acid anhydride, sulfonic acid and phosphoric acid compounds. The quantity of the mixture being added is 3%-10% of the quality of the bottom photosensitive composition. Furthermore, the background coloring dye of the bottom layer a mixture selected from the group consisting of Victoria pure blue, basic brilliant blue, oil-soluble blue, crystal violet, ethyl violet, methyl violet and methylene blue. The quantity of the coloring dye is 1%-3% of the quality of the top photosensitive composition.

Furthermore, the composition of the top layer comprises film-forming resin, photoactive compound, photoacid generator, background coloring dye.

Furthermore, the film-forming resin of the top layer is linear phenolic resins. The weight average molecular weight of the film-forming resin is 2000∼20000. The Mw/Mn of the film-forming resin is 1.5∼20. The quality of the film-forming resin is 53.5%~65% of the quality of the top layer of the top photosensitive composition.

Furthermore, the photosensitive compound of the top layer is 1,2-Naphthoquinone-2-diazo-4-sulphonate compound or 1,2-Naphthoquinone-2-diazo-5-sulphonate compound. The esterification parent of the photosensitive compound is low-molecular-weight polyphenol compound, pyrogallol-acetone condensation polymers and/or the linear phenolic resins. The weight average molecular weight of the esterification parent is 50~20000. Mw/Mn of the esterification parent is 1.5~20. The esterification rate of the hydroxy is 10%∼80%. The mass fraction of the photosensitive compound in the top photosensitive layer is 30%∼40%.

Furthermore, the development accelerator of the top layer is a mixture comprises carboxylic acid, carboxylic acid anhydride, sulfonic acid and phosphoric acid compounds. The quantity of the mixture being added is 1%~5% of the quality of the top photosensitive composition.

Furthermore, the coloring dye of the top layer is selected from the group consisting of Victoria pure blue, basic brilliant blue, oil-soluble blue, crystal violet, ethyl violet, methyl violet and methylene blue. The quantity of the coloring dye is 0.1%~1% of the quality of the top photosensitive layer.

Furthermore, a decomposition reaction of the photoacid generator occurs in the near ultraviolet region and ultraviolet region. The light spectrum sensing range is 350~420nm. The mass percentage of the photoacid generator in the photosensitive composition of the top layer is 0.1%~0.5%.

The composition of the photosensitive composition is the following:
1. Chemical Resisting Copolymer
   The molecular weight of the chemical resistance functional resin is 1000~100000. The mass fraction of the benzyl sulfonyl amino acrylic amide in the copolymer is 5%~70%. The mass fraction of the N-aryl maleimide in the copolymer is 5%~70%. The percentage composition of the chemical-resistant functional resin in the bottom photosensitive composition is 75%∼85%.
2. The Film-forming Resin
   The film-forming resin is linear phenolic resin. The linear phenolic resin is condensation polymerized by formaldehyde and phenol in different ratio, wherein the phenol is selected from the group consisting of phenol; m-methylphenol, o-methylphenol; p-methylphenol; phenol and m-methylphenol, wherein the molar ratio between the phenol and m-methylphenol is 3:7~7:3; phenol and tert-butylphenol, wherein the molar ratio between the phenol and the tert-butylphenol is 3:1~1.5:1; m-methylphenol and p-methylphenol, wherein the molar ratio between m-methylphenol and the p-methylphenol is 9:1~5:5; m-, o-methylphenol; 2, 4-dimethyl phenol; 3, 5-dimethyl phenol; the mixture consisting of m-methylphenol and p-methylphenol modified by N-phenyl maleimide. The weight-average molecular weight of the linear phenolic resin is 2000∼20000, 2000 ~10000 or 2500∼7500. Mw/Mn of the linear phenolic resin is 1.5∼20 or 1 or 1.5∼10. If the molecular weight of the linear phenolic resin exceeds 20000, the linearity of the phenolic resin decreases, and the degree of branching increases, so that the solubility in the alkali developing solution of the phenolic resin decreases, so that the developing become difficult. If the molecular weight is too small, the alkali resistance in the developing process is weak, so that the light release film phenomenon generates easily, and the pressrun of the plate become weak. At the same time, the distinguishability of the printing plate material and the reducibility of the branch are affected. The additive amount of the film-forming resin is 53.5%~65% of the total weight of the photosensitive composition.
3. Photosensitive Compound, ie Photosensitive Agent PAC
   According to the present invention, the photosensitive compound in the photosensitive component of the positive-image PS plate and CTcP plate is naphthoquinondiazide sulfonic acid ester compound. The esterification parent of the naphthoquinondiazide sulfonic acid ester compound can be low-molecular-weight polyphenol compound or high-molecular compound such as linear phenolic resins. According to the present invention, the photosensitive agent is the 1,2-naphthoquinone-2-nitrine-4-sulphonate compound obtained through a esterification reaction via a public known method by a polycondensate reacted via 1,2-naphthoquinone-2-nitrine-4-sulfonyl chloride, a hydroxy compound, such as phenol, 3-methylphenol, 4-methyphenol or pyrogallol, and a carbonyl compound such as formaldehyde, acetone or the 1,2-naphthoquinone-2-nitrine-5-sulphonate compound obtained through a esterification reaction via a public known method by a polycondensate reacted via 1,2-naphthoquinone-2-nitrine-5-sulphonate compound, a hydroxy compound, such as phenol, 3-methylphenol, 4-methyphenol or pyrogallol, and a carbonyl compound such as formaldehyde, acetone, or both the two. The two sulphonate can be used alone. The two sulphonates can be used as combination, so as to ensure the plates has higher sensitivity and good dissolve resisting ability. The ratio of the two light-sensitive compound is 0.2:1~1:0.2 or 0.5:1∼1:0. 5. The esterification parents of the sulphonate compound are low-molecular-weight polyphenol, pyrogallol-acetone polycondensate and/or linear phenolic resins. The weighte-average molecular weight of the esterification parents are 50∼20000, wherein the Mw/Mn of which is 1.5∼20. The esterification rate of the hydroxyl is 10%~80% of the original hydroxyl. The mass fraction of the light-sensitive material in the top photosensitive layer is 30%∼40%. If the dosage of the photosensitive agent is too large, the solvent resistance capacity will be too strong, developing becomes hard, the sensitivity becomes lower and the resolution becomes lower; if the dosage of the photosensitive agent is too little, the solvent resistance capacity becomes poor, wherein the alkali resistance ability becomes poor, the phenomenon of light release film occurs easily, the printing resistant ability of the plates becomes lower.
4. Photo-Acid Generator
   The photoacid generator according to the present invention are compounds which can occurs photolysis reaction smoothly in the near ultraviolet region and ultraviolet region (320-450nm), the optimum spectrum sensing range of which is 350∼420nm. Optional representative of the photoacid genetator can be trichloromethyl triazine compound, such as 1-phenyl-3,5-double trichloromethyl triazine, l-methoxyphenyl-3, 5double trichloromethyl triazine,l-p-methoxystyrene-3,5-double trichloromethyl triazine,l-methoxyphenyl-3, 5-double trichloromethyl triazine etc The dosage of the photoacid generator is 0.1~0.5 of the total photosensitive composition by weight.
5. The Coloring Dye
   The background coloring dye according to the present invention is selected from the group consisting of Victoria pure blue, basic brilliant blue, oil-soluble blue, crystal violet, ethyl violet, methyl violet and methylene blue. In view of the absorbing to the ultraviolet will reduce the sensitivity of the printing plate material, the victoria pure blue, the basic brilliant blue and the oil-soluble blue are preferred. The quantity of the coloring dye is 1%-3% of the quality of the top photosensitive composition.

Other addition resins can be polyurethane, acetal resins, acrylic resin etc

The development accelerator of the bottom layer is selected from the group consisting of carboxylic acid, carboxylic acid anhydride, sulfonic acid and phosphoric acid compounds. Preferably, the development accelerator of the bottom layer is selected from the group consisting of citric acid, tartaric acid, maleic acid, benzoic acid, phthalic acid, hydroxybenzoic acid, dihydroxy-benzoic acid, maleic anhydride, phthalic anhydride, tetrahydro phthalic anhydride triazole.

### II. Method of Manufacturing the Plate

Method of manufacturing the lithographic plate will be described in detail as following:

### 1. Surface Treatment for Supporting Body

The supporting body according to the present invention can be aluminum or aluminum alloy, such as alloys of aluminum with silicon, copper, manganese, magnesium, chromium, zinc, lead, bismuth, nicke. In general, the known material described in the aluminum manual 4th edition (published by Light Metal Association in1990) can be used. The aluminum plate can be manufactured via the usual semi-continuous casting method (DC method) or via the continuous casting rolling method. The continuous casting rolling method is selected from the group consisting of twin-roll method, band casting process, lump casting process. The content of the dissimilar elements in the alloy is smaller than 10% by weight. Preferably the thickness of the aluminum plate is about 0.1mm~0.6mm. In addition, it is also possible to use the plastic film or paper which is laminated or steamed with aluminum or aluminum alloy. If the support is the aluminum plate, various processes is usually applied to the surface thereof according to the different purpose. As a general treating process, firstly, a degreasing or electrolytic polishing treatment and a sewage treatment are applied to clean the surface of the aluminum. Then, a mechanical surface roughening treatment and/or electrochemical surface roughening treatment is applied to give a fine surface irregularity to the surface the aluminum plate. In addition, a chemical etching treatment and a sewage treatment may be added. Then, in order to improve the abrasion of the aluminum plate surface, an anodic oxidation treatment is applied, and then hydrophilic treatment or/and hole sealing treatment is applied to the surface of the aluminum. In between these treatments, in order to avoid the treatment liquid in the previously process being taken into the next process, it is preferably to carried out a liquid removal using nip rolls and a water spray by jeting. In addition, the overflow waste in the electrolytic solution used in the electrochemical surface roughening treatment can be used as the sewage treatment liquid, but this time the water washing treatment after the sewage treatment can be omitted.

### Step 1: Degreasing-Electrolytic Grinding Treatment

Remove the rolling oil, the natural oxide film and the dirt at the aluminum plate. To uniformly roughening the electrochemical surface, an electrolytic polishing treatment to the aluminum plate is applied in an acidic aqueous solution, or the chemical etching process to the aluminum plate in an acid or alkaline aqueous solution is applied.

### Step 2: Electrolytic Polishing Treatment

The known solution for electrolytic polishing can be used. Preferably, sulfuric acid solution or phosphoric acid solution is used as the main solution. More preferably, the phosphoric acid solution is used as the main solution. All of the DC current, pulsed DC and AC are proper. The continuous DC is Preferred. The electrolytic processing device may be flat-slots, star-slots or other known electrolytic processing devices.

### Step 3: Chemical Etching Treatment in an Acid or Alkaline Aqueous Solution

The chemical etching treatment in acid or alkali solution can apply these public known method. The liquid temperature is preferably 25~90°C. Preferably, it takes 1∼120 seconds during the treatment. Preferably, the mass fraction concentration of the acidic aqueous solution is 0.5%~25%.

### Step 4: Sewage Treatment

After the etching process, when an alkali aqueous solution is used to chemical etching, due to the formation of dirt on the surface of aluminum, phosphoric acid, nitric acid, sulfuric acid, chromic acid or mixed acid containing two or more acids selected from the group consisting of phosphoric acid, nitric acid, sulfuric acid and chromic acid is used generally to cleaning the dirt. The used acid solution can dissolve 0∼5% wt aluminum. The liquid temperature is selected from room temperature to 70°C. The processing time is preferably 1∼30 seconds. Furthermore, the acidic aqueous solution can apply the waste electrolyte used in roughen the electrochemical surface. It should be take care of to avoid the aluminum plate from drying to further avoid the element in the solution used to cleaning the dirt being separated out. After the sewage treatment being ended, in order to avoid bringing the dealing liquid into the next step, a liquid removing using the nip rolls and the water spraying using jetting are preferred. But if the next step uses the same solution, the water spraying can be omitted.

### Step 5: Mechanical Surface Roughening Treatment

To obtain good aluminum supporting body, graining to the surface of the aluminum is applied usually to provide fine irregularities. The graining process is selected from known graining, brush graining, wire graining, spraying sand graining and other roughening treatment to mechanical surface. As a continuous process and mass treatment, the brush graining is preferred. In detail, jet silica-sand seriflux or aluminium hydroxide seriflux to the surface of the aluminum plate; make the nylon brush roll rotate in a speed 50500rpm to roughen the mechanical surface, wherein the diameter of the brushing is 0.2∼0.9mm. Preferably, the rotation driving motor power consumption of the brush pressing force (removing the substance power lost by the mechanical used to drive the motor) is 0.2~15kw.

### Step 6: Electrochemical Surface Roughening Treatment

DC electrochemical surface roughening treatment applies aqueous solution, the main containing of which is hydrochloric acid or nitric acid. The aqueous solution used to AC electrochemical surface roughening treatment can be 1 ∼ 100g/L hydrochloric acid or nitric acid, which is added with hydrochloric acid compounds or nitric acid compounds selected from the group selected from the group consisting of aluminum nitrate, sodium nitrate and ammonium nitrate, wherein the concentration of the hydrochloric acid compounds and the nitric acid compounds is 1g/L to the saturated.

### Step 7: Chemical Etching Treatment Using Acid or Alkaline Liquid

A chemical etching treatment is given to remove the whole face or the dirt of the fine concavo-convex sand hole formed in the mechanical surface roughening treatment and the electrochemical surface roughening treatment. Preferably, the liquid temperature is 25~90°C. It takes 1~120 seconds to treat. The concentration of the acidic aqueous solution is preferably 0.5∼25% by weight. More preferably, aluminum being dissolved in the acidic aqueous solution is 0.5∼5% by weight. Preferably, the concentration of the alkali aqueous solution is 5∼30% by weight. More preferably, aluminum dissolved in the alkaline aqueous solution is 1∼30% by weight.

### Step 8: Anodizing

In order to improve the water retention property, the abrasion resistance of the aluminum plate surface, an anodizing treatment is given. As an electrolyte used in the anodizing treatment to the aluminum plate, if a porous oxide film is formed, any electrolyte can be used. Usually, sulfuric acid, phosphoric acid, oxalic acid, chromic acid, or a mixture thereof is used. The concentration of the electrolyte is decided appropriately depending on the type of these electrolytes. The anodization treatment conditions vary depending on the electrolyte being used. That can not be lump together under one head. The amount of the anodic oxide film is preferably 1.0g /m² or more. More preferably, the amount of the anodic oxide film is 2.0~6.0g/m².

### Step 9: Hole Sealing Treatment

After being given the anodic oxidation treatment, a hydrophilic treatment to the surface of the aluminum is given as needed. In this method, the supporting body is impregnated in the sodium silicate aqueous solution, or an electrolysis is applied. (Other treatments (washing, hole sealing)) following the end of each treatment, in order to avoid bring the treatment liquid to the next step, nip rolls are used to remove the liquid, and the water washing by spraying is applied. Preferably, after the anodizing treatment, the hole sealing treatment is implemented. The hole sealing treatment is proceed by immersing in the hot aqueous solution containing inorganic salts or organic salts in hot water, or by a steam bath.

### 2. Forming of the Photosensitive Layer

Photosensitive layer composition is dissolved, dispersed to form a solution containing 2%~20% solid elements by weight, which is coated to the above-described plate being given hydrophilic sanding and is dried. Generally, the amount of the photosensitive layer composition being coated to the photosensitive layer is preferably 0.5∼2.0g/m² by weight after being dried. Along with the reduction of the coating amount, the strength of the film reduces. Along with the increase in the coating amount, the exposure amount increases, the strength of the film enhance.

The composition of the photosensitive layer is dissolved in one, two or three solvents. According to the present invention the solvents can be acetone, methyl ethyl ketone, cyclohexane, acetic ether, dichloroethylene, tetrahydrofuran, methylbenzene, ethylene glycol monomethyl ether, ethylene glycol monoethyl ether, glycol dimethyl ether, propylene glycol monomethyl ether, propylene glycol monoethyl ether, ethyl phthalein acetone, cyclohexanone, diacetone alcohol, ethylene glycol monomethyl ether acetate, ethylene glycol ethyl ether acetate, ethylene glycol monoethyl isopropyl ether, Ethylene glycol monobutyl ether acetate, 3-Methoxypropanol, methoxy methoxy ethyl alcohol, diethylene glycol monomethyl ether, etc. These solvents can be used alone or in combination.

In order to improve the coating appearance, surfactants can be added to the photosensitive layer of the positive-image lithographic printing plate.

The coating method of the photosensitive layer can be scraper stick coating, a method of coating by a Extrusion type coating machine, rotation coating, soaking coating, anilox roller coating, air scissors coating , roll coating, scraper blade coating, curtain coating method or using a ball coater etc. one skilled in the art will understand that the above method are not the limitation to the present invention.

### 3. Exposure and Development Processing

According to the present invention, the exposure light source of the positive-image lithographic printing plate printing plate is a carbon arc lamp, a high pressure mercury lamp, ammonia lamp, a metal halide lamp, a fluorescent lamp, tungsten lamp, halide torch, 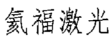 , hydrogen ion laser, FD-YAG laser, a He-Ne Laser, a semiconductor laser (350nm~450nm). The photosensitive layer is exposed. After being exposed to these known light source. A developed by treatment is given in an alkaline solution, i.e., the plate is dipped in the developing liquid. At the temperature range 0~60°C, preferably the temperature range 15~40°C, the coating layer in the exposed regions are dissolved in the developing liquid by the method of brush scrub or spray, so that the coating layer in the exposed regions are removed from the aluminum plate base and the non-exposed regions are retained in the aluminum plate, so that an image is formed to the surface of the aluminum plate supporting body.

The lithographic printing plate manufacturing method may further comprises a version revising process and a process of adding protecting glue, etc.

### IV. the method of detecting the plate

### 1. Chemical Resistance Detection Method

The plate being obtained via the above method is cut to form a plurality of test strips with the size 10cm * 2cm. A soaking experiment is applied using a mixed solvent. The composition of the mixed solvent is diacetone alcohol : water = 4:1. One end of the density of the test strip is tested via X-Rite 528 type densitometry: the end whose density will be measured is immersed into the testing solvent; removed the end 10 minutes later; wipe dry the end by a clean soft cloth; measure the density value of the immersion position via the X-Rite 528 type densitometry. Calculate the difference value of the density loss. The bigger the difference value is, the worse the solvent resistance ability is.

### 2. UV-CTP Sensitivity Test

The manufacturing of the plates applies a kore UV-CTP platesetter (UV426E3X +). The light source being applied is 405nm semiconductor laser. The type of the UV-CTP platesetter is external drum type. The rotate speed is 900 rpm. The starting value of the laser energy is 30mw. One exposure is applied once the laser energy increase 5mw until the maximum laser energy 70mw. Then a hu.q PT-125 development machine is used to develop. The developer liquid is "Kuroki" HUV-PN series developer liquid; water is added by a ratio 1: 4 to dilute the developer liquid. It takes 25 seconds to develop at the temperature 25°C. When the actual output of the plain net is 50±0.5%, the laser energy being used is the appropriate exposure energy. The laser energy is used to represent the sensitivity. The greater the value is, the lower the sensitivity is. The smaller the value is, the higher the sensitivity is.

### 3. Resolution Measurement

The kore UV-CTP platesetter (UV426E3X +) is used to make the plates. The resolution of the device is 2540dpi, which is used to expose to the plate (making1~4 pixels Yin and Yang lines). Then the hu.q PT-125 development machine is used to develop. The developer liquid is "Kuroki" HUV-PN series developer liquid; water is added by a ratio 1: 4 to dilute the developer liquid. It takes 25 seconds to develop at the temperature 25°C. The coreduction of the Yin and Yang lines represents the resolution ratio of the plates. The smaller the pixel is, the higher the resolution ratio is.

### 4. Testing the Developing Latitude

The exposure is given on the kore UV-CTP platesetter(UV426E3X +) with an exposure, the value of which is 1.3 times of the optimum exposure. Then develop is realized at 23°C in different development time (10s, 20s, 30s, 40s). Under these conditions, the difference between the highest and lowest values of the developing time which reaches the requirements (there is no office copy in the space; the density OD <0.29; Coating Field unabated film; Density OD values>1.43; 3%~99% outlets are reduced) is the developing latitude of the plate.

### 5. Simulation Experiment for Testing The Pressrun Rate

The plate being exposed to develop is cut to form some samples with the size of 8cm*30cm. The samples are fixed into a container. The sealable capacity of the container is about 1000ml. The chemicals as illustrated in table 1 are added into the container. It is worth to be mentioned that the chemicals must contact with the surface of the samples. Keep turning the container continuously for 20 minutes to study the density losses of the layout coating. The density values are measured via an X-Rite type 528 densitometer. The smaller the layout density is, the greater the coating loss is and the worse the pressrun is.

**Table 1 experimental formula of the simulation experiment for testing the pressrun**

| | |
|---|---|
| H₂O | 225ml |
| isopropanol | 75ml |
| phosphoric acid 10ml | 23°C |
| emery | 34.6g |
| rubber ball | 5(R=3cm) |

### 6. Imulation Experiment for Testing The UV Ink Pressrun

The plate being exposed is cut to form some samples with the size of 8cm*30cm. The samples are fixed into a container. The sealable capacity of the container is about 1000ml. The chemicals as illustrated in table 2 are added into the container. It is worth to be mentioned that the chemicals must contact with the surface of the samples. Keep turning the container continuously for 20 minutes to study the density losses of the layout coating. The density values are measured via an X-Rite type 528 densitometer. The smaller the layout density is, the greater the coating loss is and the worse the pressrun is.

**Table 2 experiment formula of the UV ink pressrun simulation experiment**

| | |
|---|---|
| H₂O | 100ml |
| isopropanol | 75ml |
| ethylene glycol monomethyl ether | 115 |
| phosphoric acid 10ml | 23°C |
| emery | 34.6g |
| rubber ball | 5(R=3cm) |

The advantageous of the present invention are: the solvent resistance of the positive UV-CTP plate is improved. At the same time, the sensitivity, resolution, developing tolerance and the pressrun of the plates is improved and is adopted to UV ink printing. The present invention is described via the embodiments as following, but the present invention is not limited to the embodiments.

### DETAILED DESCRIPTION OF THE PREFERRED EMBODIMENT

### Embodiment 1

31.0g (0.36mol) methacrylic acid, 39.1g (0.36mol) ethyl chloroformate and 200ml acetonitrile are added into a 500ml flask with three mouth to from a mixture, which is provided with a stirrer, a thermometer, and a constant pressure funnel. The stirrer is started to stir the mixture. The mixture is cooled via an ice-water bath. 36. 4g (0. 36mol) triethylamine is dropwise added in 1 hour. After the dropwise adding is finished, the ice-water bath is removed. The funnel is replaced by a condenser. Continue to stir 30 minutes at the room temperature. 60.08g 1-(4-amino phenyl)-N-methyl-methyl sulfamide is added into the mixture. The mixture is stir 1h at 70°C. The reaction mixture is cooled and then is added into 1L water and is stir for 30 minutes. Then the reaction mixture is filtered and is washed by 500ml water. 30g white powdery N-[4-((N-methyl-amino sulfonyl) methyl) phenyl]-2-methyl-2-acrylamide is obtained after being dried.

### Embodiment 2

### The synthesis of the acrylic resin(FSR1)

### Embodiment 2

### The synthesis of the acrylic resin(FSR1)

A stirrer, a condenser and a dropping funnel are provided to a 500ml flask with four mouth. Nitrogen gas is inlet into the flask. 105g ethyl cellosolve, 0.6g dibenzoyl peroxide and 15g said APDMAA are added into the flask. The stirrer is started to stir and to help the mixture in the flask to dissolve. 11.5g methacrylic acid,3.5g styrene, 10g methacrylic-2-hydroxy ethyl ester and 5g N-phenylmaleimide are added . after being stir 10 minutes, the temperature is heated up to 80°C. After the reaction of 1 hour, a mixed monomer(15g APDMAA, 11.5g methacrylic acid, 3.5g styrene, 10g methacrylic-2-hydroxy ethyl ester and 5g N-phenylmaleimide are dissolved into 105ml ethyl cellosolve) . The dropping is finished in 1 hour. The reaction was continued for 4 hours. After the reaction is finished, the temperature is cooled to room temperature. 0. 5g hydroquinone (be dissolved in 50ml ethyl cellosolve) is added. The reaction mixture is stir for 10 minutes and then is added into 4 liters of water slowly to obtain white solid. Then through the steps of filtering, washing three times, dring in a vacuum oven to obtain the acrylic resin FSR1. The weight-average molecular of the FSR1 is tested via a gel permeation chromatography (Aglilient Technologies 1120 Compact LC) (GPC) . The testing conditions are as follows: the polystyrene is used as standard; a GPC column is used. The size of the GPC column is 708*300MM; the wave length of the testing is 220nm; the concentration of the sample being injected is 1.0mg /ml; the volume of the sample being injected is 20µl ; the mobile phase being used is DMF.

### Embodiment 3

### The synthesis of the acrylic resin(FSR2)

A stirrer, a condenser and a dropping funnel are provided to a 500ml flask with four mouth. Nitrogen gas is inlet into the flask. 105g ethyl cellosolve, 0.6g dibenzoyl peroxide and 15g said APDMAA are added into the flask. The stirrer is started to stir and to help the mixture in the flask to dissolve. 13.5g methyl methacrylate,3.5g methacrylic acid, 10g acrylonitrile and 5g N-phenylmaleimide are added. after being stir 10 minutes, the temperature is heated up to 80°C. after the reaction of 1 hour, a mixed monomer(15g APDMAA, 13.5g methyl methacrylate,3.5g methacrylic acid, 10g acrylonitrile and 5g N-phenylmaleimide are dissolved into 105ml ethyl cellosolve) . the dropping is finished in 1 hour. The reaction was continued for 4 hours. After the reaction is finished, the temperature is cooled to room temperature. 0. 5g hydroquinone ( be dissolved in 50ml ethyl cellosolve) is added. The reaction mixture is stir for 10 minutes and then is added into 4 liters of water slowly to obtain white solid. Then through the steps of filtering, washing three times, dring in a vacuum oven to obtain the acrylic resin FSR2. The weight-average molecular of the FSR2 is tested via a gel permeation chromatography (Aglilient Technologies 1120 Compact LC) (GPC) . The testing conditions are as follows: the polystyrene is used as standard; a GPC column is used. The size of the GPC column is 708*300MM; the wave length of the testing is 220nm; the concentration of the sample being injected is 1.0mg /ml; the volume of the sample being injected is 20µl ; the mobile phase being used is DMF; the temperature of the column is 35°C. The performance index, such as the weight-average molecular, Mn, molecular weight distribution(MWD) of the sample resin being synthesized can be obtained. The weight-average molecular is 30000.

### Embodiment 4

### The synthesis of the acrylic resin(FSR3)

A stirrer, a condenser and a dropping funnel are provided to a 1000ml flask with four mouth. Nitrogen gas is inlet into the flask. 400ml ethyl cellosolve, 0.8g dibenzoyl peroxide and 7g said APDMAA are added into the flask. The stirrer is started to stir and to help the mixture in the flask to dissolve. 8g acrylonitrile, 10g ethyl methacrylate and 12g Propylene sulfonamide are added. after being stir 10 minutes, the temperature is heated up to 80°C. After the reaction of 1 hour, a mixed monomer(7g APDMAA, 5g methyl methacrylate are dissolved into 50ml ethyl cellosolve) . The dropping is finished in 1 hour. The reaction was continued for 4 hours. After the reaction is finished, the temperature is cooled to room temperature. 0. 5g hydroquinone ( be dissolved in 50ml ethyl cellosolve) is added. The reaction mixture is stir for 10 minutes and then is added into 4 liters of water slowly to obtain white solid. Then through the steps of filtering, washing three times, dring in a vacuum oven to obtain the acrylic resin FSR3. The weight-average molecular of the FSR3 is tested via a gel permeation chromatography (Aglilient Technologies 1120 Compact LC) (GPC) . The testing conditions are as follows: the polystyrene is used as standard; a GPC column is used. The size of the GPC column is 708*300MM; the wave length of the testing is 220nm; the concentration of the sample being injected is 1.0mg /ml; the volume of the sample being injected is 20µl ; the mobile phase being used is DMF; the temperature of the column is 35oC. The performance index, such as the weight-average molecular, Mn, molecular weight distribution(MWD) of the sample resin being synthesized can be obtained. The weight-average molecular being concerned here is 37000.

### Embodiment 5

### The synthesis of the acrylic resin(FSR4)

A stirrer, a condenser and a dropping funnel are provided to a 1000ml flask with four mouth. Nitrogen gas is inlet into the flask. 400ml ethyl cellosolve, 0.6g dibenzoyl peroxide and 3g said APDMAA are added into the flask. The stirrer is started to stir and to help the mixture in the flask to dissolve. 3g methacrylic acid, 5g styrene, 3g acrylonitrile, 9g N-phenyl maleimide and 15g acrylic amide are added. after being stir 10 minutes, the temperature is heated up to 80°C. after the reaction of 1 hour, a mixed monomer(5g APDMAA and 9g N-phenyl maleimid are dissolved into 50ml ethyl cellosolve) . The dropping is finished in 1 hour. The reaction was continued for 4 hours. After the reaction is finished, the temperature is cooled to room temperature. 0.5g hydroquinone ( be dissolved in 50ml ethyl cellosolve) is added. The reaction mixture is stir for 10 minutes and then is added into 4 liters of water slowly to obtain white solid. Then through the steps of filtering, washing three times, dring in a vacuum oven to obtain the acrylic resin FSR4. The weight-average molecular of the FSR4 is tested via a gel permeation chromatography (Aglilient Technologies 1120 Compact LC) (GPC) . The testing conditions are as follows: the polystyrene is used as standard; a GPC column is used. The size of the GPC column is 708*300MM; the wave length of the testing is 220nm; the concentration of the sample being injected is 1.0mg /ml; the volume of the sample being injected is 20µl ; the mobile phase being used is DMF; the temperature of the column is 35oC. The performance index, such as the weight-average molecular, Mn, molecular weight distribution(MWD) of the sample resin being synthesized can be obtained. The weight-average molecular being concerned here is 52000.

### Embodiment 2-4

### 1. The preparation of the aluminum plate base being used to testing

The plate base being used to the embodiments and the alternatives is processed via the following process to obtain a hydrophilic surface:
(1) a decontamination is provided to the aluminum plate. The surface of the plate base is cleaned by organic solvents, acid water or alkaline water, wherein the dissolved load is 5~8g/m²;
(2) grain electrolyzing: the graphic part of the plate material should have good lipophilia. The blank part of the plate material should have good hydrophily. Graining of the aluminum is needed to make the blank part have good hydrophily, so that the blank grain part can store water but not oleophylic. The forming of the grain applied the method of electrolyzing. The aluminum plate and the graphite are used as two electrodes. The electrolyte is 6~20g /l hydrochloric acid solution. 50HZ alternating current is applied. The electric current is 20-100A/dm², the liquid temperature is 30~60°C, electrolysis time is 5∼90 seconds. Ra is controlled between 0.5µl and 0.6µl.
(3) Anodic Oxidation

In order to improve the mechanical strength of the surface of the aluminum plate , to enhanced wear resistance and to improve the hydrophilic, surface of the aluminum plate is need to be anodized.15%-30% sulfuric acid solution is used. The temperature is 20~60. It takes 5∼250 seconds to electrolysis. The concentration of the aluminum ion is 0.5~5g/l. The direct current is used. The current is 1~15A/dm². The controlled oxide film = 2∼3g/m².

### (4) Hole Sealing

After the step electrolysis and anodic oxidation, the surface of the aluminum plate has a lot of microporous. The purpose of hole sealing is to block the microporous. The purpose of hydrophilization and hole sealing are achieved via sodium silicate solution.

PS photosensitive layer coating solution is prepared according to the following formula:

### 2. Preparation of the Bottom Photosensitive Layer Coating Liquid

### (1) The materials being used to the bottom photosensitive layer coating solution are illustrated as following:

| | |
|---|---|
| Solvent resistance copolymer FSR1-FSR4 (the present invention) | 5.48 parts by weight |
| photosensitizer 2M412 (2.1.4 esterification formed by diazonium naphthoquinone sulfonyl chloride and pyrogallol condensation acetone resin) | 1. 02 parts by weight |
| THPA (Puyang Henan) | 0.34 parts by weight |
| methyl violet other components: | 0.16 parts by weight |
| ethyl cellosolve | 75 parts by weight |
| N,N-dimethylformamide | 10 parts by weight |
| MEK | 15 parts by weight |

(2)The coating solution being prepared is coated to said plate base which is given hydrophilic graining and is dried. The size of the plate base is 400*510*0. 27mm. Drying is applied at 150°C in an oven for 3 minutes. Suitable rotational speed is controlled during spin coating, so that the coating thickness of the plate sample is 0.9g/m², so as to obtain the bottom plate D1-D4.

### 3. The preparation of the top photosensitive layer coating liquid

(1) The materials being used to the top photosensitive layer coating solution are illustrated as following:

| | |
|---|---|
| linear phenolic resin NV-225 (Qingdao Blue Sail New Materials Co., Ltd.) | 3.79 parts by weight |
| linear phenolic resin NV-150 (Qingdao Blue Sail New Materials Co., Ltd.) | 0.38 parts by weight |
| photosensitizer 3PP412 (2.1.4 esterification formed by diazonium naphthoquinone sulfonyl resin Qingdao Blue Sail New Materials Co., Ltd.) | 1.39 parts by weight |
| photosensitizer 2M512 (2.1.5 esterification formed by diazonium naphthoquinone sulfonyl chloride and pyrogallol condensation acetone resin Qingdao Linefan new Material Co., Ltd.) | 0.92 parts by weight |
| triazine B (Qingdao Blue Sail New Materials Co, Ltd. ) | 0.03 parts by weight |
| THPA (puyang Henan) | 0.15 parts by weight |
| methyl violet (LinTong Jiangsu) | 0.04 parts by weight |
| other components: | |
| ethyl cellosolve | 80 parts by weight |
| MEK | 20 parts by weight |

(2)The coating solution being prepared is coated to plate sample D1-D4 which is coated with a bottom layer. Drying is applied at 120°C in an oven for 3 minutes. Suitable rotational speed is controlled during spin coating, so that the coating thickness of the plate sample is 0.8g/m², so as to obtain the bottom plate T1-T4.

### Alternative mode 1

### 3. The recipe to prepare the PS plate sensitivity layer coating liquid is illustrated as following:

| | |
|---|---|
| linear phenolic resin NV-225 (Qingdao Blue Sail New Materials Co., Ltd.) | 5.49 parts by weight |
| Pyrogallol condensation acetone resins NPA-3 (Qingdao Blue Sail New Materials Co., Ltd.) | 1.05 parts by weight |
| photosensitizer 2M512 (2.1.5 esterification formed by diazonium naphthoquinone sulfonyl chloride and pyrogallol condensation acetone resin Qingdao Linefan new Material Co., Ltd.) | 3.26 parts by weight |
| triazine B (Qingdao Blue Sail New Materials Co., Ltd.) | 0.04 parts by weight |
| THPA (PuYang Henan) | 0.21 parts by weight |
| ethyl violet (Qingdao Blue Sail New Materials Co, Ltd. ) parts by weight | 0. 16 |
| ethyl cellosolve | 80 parts by weight |
| MEK | 20 parts by weight |

### Alternative mode 2

| | |
|---|---|
| The recipe to prepare the UV-CTP plate sensitivity layer coating liquid is illustrated linear phenolic resin NV-225 (Qingdao Blue Sail New Materials Co., Ltd.) | 409 parts by weight |
| Pyrogallol condensation acetone resins NPA-3 (Qingdao Blue Sail New Materials Co., Ltd.) | 1.0 parts by weight |
| Addition resin R1-R4 FSR1-FSR4 (the present invention) | 1.2 parts by weight |
| photosensitizer 2M512 (2. 1. 5 esterification formed by diazonium naphthoquinone sulfonyl chloride and pyrogallol condensation acetone resin Qingdao Linefan new Material Co., Ltd.) | 1. 09 parts by weight |
| photosensitizer 3PP412 (2.1.4 esterification formed by diazonium naphthoquinone sulfonyl resin Qingdao Blue Sail New Materials Co., Ltd.) | 2.17 parts by weight |
| THPA (PuYang Henan) | 0.25 parts by weight |
| triazine B (Qingdao Blue Sail New Materials Co., Ltd.) | 0.4 parts by weight |
| ethyl violet (Qingdao Blue Sail New Materials Co, Ltd. ) | 0.5 parts by weight |
| ethyl cellosolve | 80 parts by weight |
| MEK | 20 parts by weight |

Two kinds of coating solution being prepared to be a comparison are coated to said plate base which is given hydrophilic graining and is dried. The size of the plate base is 400*510*0. 27mm. Drying is applied at 120°C in an oven for 3 minutes. Suitable rotational speed is controlled during spin coating, so that the coating thickness of the plate sample is 1.8g/m2, so as to obtain the bottom plate C1-C2.
experimental result:

**Table 3 the test results of PS plate**

| | Solvent resistance | Exposure unit | Clean series of the grayscale | lattice point reduction | simulation experiment for pressrun | simulation experiment for pressrun of UV ink |
|---|---|---|---|---|---|---|
| T1 | 0.68 | 12 | 3 | 1-99% | 1.21 | 1.11 |
| T2 | 0.65 | 13 | 3 | 1-99% | 1.19 | 1.11 |
| T3 | 0.70 | 13 | 3 | 1-99% | 1.24 | 1.09 |
| T4 | 0.62 | 14 | 3 | 1-99% | 1.11 | 1.12 |
| C1 | 0.42 | 14 | 3 | 2-98% | 0.56 | 0.35 |
| C2 | 0.55 | 14 | 3 | 1-99% | 1.1 | 0.56 |

**Table 4 test results of digit plate**

| | sensitivity /mv | latitude of development | definition |
|---|---|---|---|
| T1 | 45 | 20 | 1 pixel |
| T2 | 50 | 25 | 2 pixel |
| T3 | 55 | 20 | 1 pixel |
| T4 | 55 | 20 | 2 pixel |
| C1 | 60 | 15 | 3 pixel |
| C2 | 60 | 10 | 3 pixel |

The conclusion of the present invention can be fully proved by the above testing results of the experiments.

## Claims

1. A printing plate material for positive-image Presensitized Plate "PS plate" and Computer-to-Conventional Plate "CTcP" lithographic printing plate, comprising a hydrophilic layer, wherein said hydrophilic layer is coated with a bottom layer, wherein said bottom layer is coated with a top layer, wherein said bottom layer and said top layer are sensitive to the visible light and the UV, wherein said bottom sensitive layer is made of chemical resistant functional resin, light-sensitive compound, developing accelerant and background coloring dye, wherein said top layer is made of film-forming resin, light-sensitive compound, developing accelerant, photo-acid generator and background coloring dye, wherein said chemical resistant functional resin is a copolymer having a Formula I of 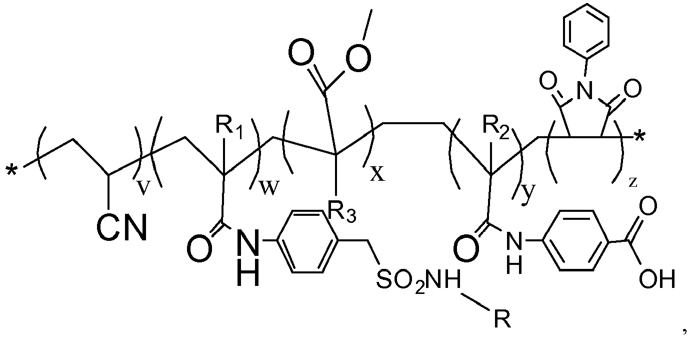 wherein R is selected from the group consisting of H, C₁~C₄ alkyl groups and aryl groups, wherein R₁, R₂ and R₃ respectively represent H or CH₃, wherein v, w, x, y, z respectively represent the mass fractions of the monomer components in the copolymer molecule, wherein each of the mass fractions ranges from 5% to 70%, wherein the sum of the mass fractions of v, w, x, y and z is 100%, wherein the weight average molecular weight of the copolymer ranges from 1000 to 100000, wherein the mass fraction of the benzyl sulfonyl amino acrylic amide is 5%~70% in the copolymer, and the mass fraction of the N-aryl maleimide is 5%~70% in the copolymer, wherein the weight percentage content of the chemical-resistant functional resin is 75∼85% in the bottom photosensitive layer.

2. The printing plate material, as recited in claim 1, wherein the light sensitive compound is selected from the group consisting of 1,2-naphthoquinone-2-diazo-4-sulphonate compound and 1,2-naphthoquinone-2-diazo-5-sulphonate compound, wherein the esterification parent of the sulphonate compound are selected from the group consisting of low-molecular-weight polyphenol compounds, pyrogallol-acetone condensation polymers and linear phenolic resins, wherein the weight average molecular weight of the esterification parent is 50∼20000, wherein Mw/Mn is 1.5-20, wherein the esterification rate of the hydroxy is 10%~80%, wherein the mass fraction of the photosensitive compound is 2%~20% in the bottom photosensitive layer, wherein the weight percentage content of the photosensitive compound is 30%∼40% in said top photosensitive layer.

3. The printing plate material, as recited in claim 1 or claim 2, wherein said development accelerator is selected from the group consisting of carboxylic acid, carboxylic acid anhydride, sulfonic acid and phosphoric acid compounds, wherein the amount of said development accelerator added into said bottom light sensitive layer is 3%~10%weight of the photosensitive compound of said bottom light sensitive layer, wherein the amount of said development accelerator added into said top photosensitive layer is 1%~5% weight of the photosensitive compound of said top photosensitive layer.

4. The printing plate material, as recited in claim 1 or claim 2, wherein the background coloring dye is selected from the group consisting of Victoria pure blue, basic brilliant blue, oil-soluble blue, crystal violet, ethyl violet, methyl violet and methylene blue, wherein the mass fraction of the coloring dye is 1%~3% in said bottom photosensitive layer, wherein the mass fraction of the coloring dye is 0.1%~1% in said top photosensitive layer.

5. The printing plate material, as recited in claim 1, wherein said film-forming resin is linear phenolic resin, wherein the weight-average molecular weight of the linear phenolic resin is 2000~20000, wherein Mw/Mn of the linear phenolic resin is 1.5-20, wherein the amount of the film-forming resin is 53.5%~65% weight of the photosensitive compound of said top photosensitive layer.

6. The printing plate material, as recited in claim 5, wherein said linear phenolic resin is polycondensed by methanol and at least one phenolic substance selected from the group consisting of phenol, m-methylphenol, o-methylphenol, p-methylphenol, a mixture containing phenol and m-methylphenol, a mixture containing phenol and tert-butylphenol, a mixture containing m-methylphenol and p-methylphenol, m-,o-methylphenol, 2, 4-dimethyl phenol, 3, 5-dimethyl phenol and a mixture consisting of m-methylphenol and p-methylphenol modified respectively by N-phenyl maleimide, wherein the mixture containing phenol and m-methylphenol has a molar ratio of 3:7~7:3 of phenol and m-methylphenol, wherein the mixture containing phenol and tert-butylphenol has a molar ratio of 3:1 ~ 1.5:1 of phenol and tert-butylphenol, wherein the mixture containing m-methylphenol and p-methylphenol has a molar ratio of 9:1 ~5:5 of m-methylphenol and p-methylphenol, wherein the weight-average molecular weight of the linear phenolic resin is 2000~10000 or 2500~7500, wherein the amount of the linear phenolic resin added is 53.5%~65% of the total weight of the photosensitive compounds of said top photosensitive layer.

7. The printing plate material, as recited in claim 1, wherein said photo-acid generator is a compound which is able to be decomposed in the near ultraviolet region and ultraviolet region, wherein said photo-acid generator has a light spectrum sensing range of 350~420nm, wherein the mass percentage of the photo acid generator is 0.1%∼0.5% in the photosensitive compound of said top photosensitive layer.

8. The printing plate material, as recited in claim 1, 2, 5 or 6, wherein said PS plate and CTcP plate is exposed and is given a developing process to form said printing plate material for positive-image PS plate and CTcP lithographic printing plate, wherein the developing process comprises a step of plate modifying and a step of coating.

## Patentansprüche

1. Ein Druckplattenmaterial für positive Abbildungsvorbelichtungsplatten "PS-Platte" und Computer-zu-Konventionellen Platten "CTcP" Lithographie-Druckplatte, bestehend aus einer hydrophilen Schicht, wobei besagte hydrophile Schicht mit einer unteren Schicht beschichtet ist, wobei besagte untere Schicht mit einer oberen Schicht beschichtet ist, wobei besagte untere Schicht und besagte obere Schicht empfindlich gegenüber sichtbarem Licht und UV sind, wobei besagte untere empfindliche Schicht aus chemikalienbeständigem funktionalen Harz, lichtempfindlichem Verbindungsmittel, Entwicklungsbeschleuniger und Hintergrundfärbemittel besteht, wobei besagte obere Schicht aus filmbildendem Harz, lichtempfindlichem Verbindungsmittel, Entwicklungsbeschleuniger, Foto-Säuregenerator und Hintergrundfärbemittel besteht, wobei besagtes chemikalienbeständiges funktionales Harz ein Copolymer mit der Formel I ist 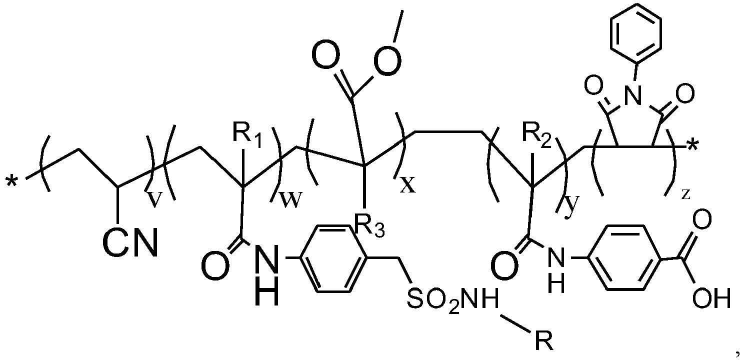 wobei R aus der Gruppe von H, Ci-C4-Alkylgruppen und Arylgruppen ausgewählt ist, wobei R1, R2 und R3 jeweils H oder CH3 repräsentieren, wobei v, w, x, y, z die Massenanteile der Monomerkomponenten im Copolymermolekül repräsentieren, wobei jeder der Massenanteile im Bereich von 5% bis 70% liegt, wobei die Summe der Massenanteile von v, w, x, y und z 100% beträgt, wobei das gewichtete durchschnittliche Molekulargewicht des Copolymers im Bereich von 1000 bis 100 000 liegt, wobei der Massenanteil des Benzylsulfonylaminacrylamids im Copolymer 5%-70% beträgt und der Massenanteil des N-Arylmaleimids im Copolymer 5%-70% beträgt, wobei der Gewichtsprozentsatz des chemikalienbeständigen funktionalen Harzes in der unteren lichtempfindlichen Schicht 75-85% beträgt.

2. Das Druckplattenmaterial, wie in Anspruch 1 angegeben, wobei das lichtempfindliche Verbindungsmittel aus der Gruppe von 1,2-Naphthochinon-2-diazo-4-sulfonat-Verbindungen und 1,2-Naphthochinon-2-diazo-5-sulfonat-Verbindungen ausgewählt ist, wobei die Esterifizierungsgrundlage der Sulfonatverbindung aus der Gruppe von niedermolekularen Polyphenolverbindungen, Pyrogallol-Aceton-Kondensationspolymeren und linearen Phenolharzen ausgewählt ist, wobei das gewichtete durchschnittliche Molekulargewicht der Esterifizierungsgrundlage 50-20 000 beträgt, wobei Mw/Mn 1,5-20 beträgt, wobei der Esterifizierungsgrad des Hydroxys 10%-80% beträgt, wobei der Massenanteil des photosensitiven Verbindungsmittels 2%-20% in der unteren lichtempfindlichen Schicht beträgt, wobei der Gewichtsprozentsatz des photosensitiven Verbindungsmittels in der genannten oberen lichtempfindlichen Schicht 30%-40% beträgt.

3. Das Druckplattenmaterial, wie in Anspruch 1 oder 2, wobei der Entwicklungsbeschleuniger aus der Gruppe von Carbonsäuren, Carbonsäureanhydriden, Sulfonsäuren und Phosphorsäureverbindungen ausgewählt wurde, wobei die Menge des Entwicklungsbeschleunigers, die der unteren lichtempfindlichen Schicht zugesetzt wird, 3%-10% in der Verbindung der unteren lichtempfindlichen Schicht beträgt, wobei die Menge des Entwicklungsbeschleunigers, die der oberen lichtempfindlichen Schicht zugesetzt wird, 1%-5% in der Verbindung der oberen lichtempfindlichen Schicht beträgt.

4. Das Druckplattenmaterial, wie in Anspruch 1 oder 2, wobei das Hintergrundfärbemittel aus der Gruppe von Victoria Pure Blue, Basic Brilliant Blue, Öllöslichem Blau, Kristallviolett, Ethylviolett, Methylviolett und Methylenblau ausgewählt wurde, wobei der Massenanteil des Farbstoffs in der unteren lichtempfindlichen Schicht 1-3 % beträgt, wobei der Massenanteil des Farbstoffs in der oberen lichtempfindlichen Schicht 0,1-1 % beträgt.

5. Das Druckplattenmaterial, wie in Anspruch 1, wobei das filmbildende Harz ein lineares Phenolharz ist, wobei das gewichtete durchschnittliche Molekulargewicht des linearen Phenolharzes 2000-20 000 beträgt, wobei Mw/Mn des linearen Phenolharzes 1,5-20 beträgt, wobei die Menge des filmbildenden Harzes 53,5%-65% der lichtempfindlichen Verbindung der lichtempfindlichen Schicht beträgt.

6. Das Druckplattenmaterial, wie in Anspruch 5, wobei das lineare Phenolharz durch Methanol und mindestens eine phenolische Substanz polykondensiert ist, ausgewählt aus der Gruppe bestehend aus Phenol, m-Methylphenol, o-Methylphenol, p-Methylphenol, einer Mischung aus Phenol und m-Methylphenol, einer Mischung aus Phenol und tert-Butylphenol, einer Mischung aus m-Methylphenol und p-Methylphenol, m-, o-Methylphenol, 2,4-Dimethylphenol, 3,5-Dimethylphenol und einer Mischung aus m-Methylphenol und p-Methylphenol, polykondensiert wird, jeweils modifiziert durch N-Phenylmaleimid (wobei die Mischung, die Phenol und m-Methylphenol enthält, ein Molverhältnis von 3:7 bis 7:3 von Phenol und m-Methylphenol aufweist, wobei die Mischung, die Phenol und tert-Butylphenol enthält, ein Molverhältnis von 3:1 bis 1,5:1 aufweist Phenol und tert-Butylphenol, wobei die Mischung, die m-Methylphenol und p-Methylphenol enthält, ein Molverhältnis von 9:1 bis 5:5 von m-Methylphenol und p-Methylphenol aufweist), wobei das gewichtete durchschnittliche Molekulargewicht des linearen Phenolharzes 2 000-10 000 oder 2 500-7 500 beträgt, wobei die Menge des zugefügten linearen Phenolharzes 53,5%-65% des Gesamtgewichts der lichtempfindlichen Verbindungen der oberen genannten lichtempfindlichen Schicht beträgt.

7. Das Druckplattenmaterial, wie in Anspruch 1, wobei der Foto-Säuregenerator eine Verbindung ist, die im nahen ultravioletten Bereich und im ultravioletten Bereich zerlegt werden kann, wobei der Photosäuregenerator einen des Lichtspektrum-Sensorbereichs 350-420 nm beträgt, wobei der Massenanteil des Photosäuregenerators in der lichtempfindlichen Verbindung der oberen Schicht 0,1%-0,5% beträgt.

8. Das Druckplattenmaterial, wie in Anspruch 1, 2, 5 oder 6, wobei die besagte PS-Platte und CTcP-Platte belichtet und einem Entwicklungsprozess unterzogen wird, um das Druckplattenmaterial für eine PS-Platte mit positivem Bild und eine lithografische CTcP-Druckplatte zu bilden, wobei Der Entwicklungsprozess umfasst einen Schritt der Plattenmodifizierung und einen Schritt der Beschichtung.

## Revendications

1. Matériau de plaque d'impression pour une plaque présensibilisée à l'image positive " plaque PS " et une plaque conventionnelle ordinateur-plaque "CTcP" pour une plaque d'impression lithographique, comprenant une couche hydrophile, ladite couche hydrophile étant recouverte d'une couche inférieure, ladite couche inférieure étant recouverte d'une couche supérieure, ladite couche inférieure et ladite couche supérieure étant sensibles à la lumière visible et aux radiations ultraviolettes, dans laquelle la couche sensible inférieure est constituée d'une résine fonctionnelle chimiquement résistante, d'un composé photosensible, d'un accélérateur de développement et d'un colorant de fond, dans laquelle la couche supérieure est constituée d'une résine filmogène, d'un composé photosensible, d'un accélérateur de développement, d'un générateur de photo-acide et d'un colorant de fond, dans laquelle la résine fonctionnelle chimiquement résistante est un copolymère de formule I 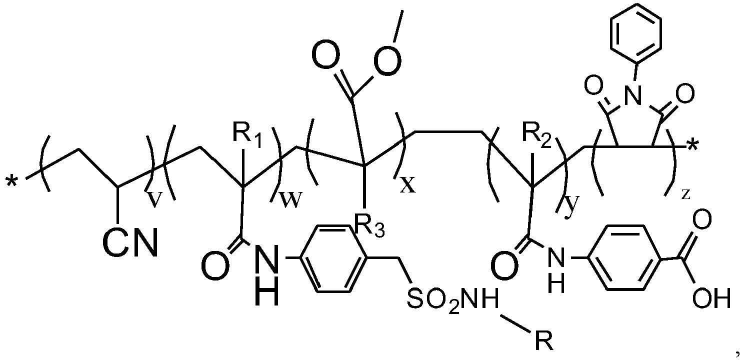 où R est choisi dans le groupe constitué de H, de groupes alkyle Ci-C4 et de groupes aryle, où R₁, R₂ et R₃ représentent H ou CH3, respectivement, où v,w,x,y,z représentent les fractions de masse des composants monomères dans la molécule de copolymère, respectivement, où chaque fraction de masse est comprise entre 5% - 70%, où la somme des fractions de masse de v,w,x,y et z est de 100%, dans lequel le poids moléculaire moyen en poids du copolymère est compris entre 1000 et 100 000, dans lequel la fraction massique de benzylsulfonylaminoacrylamide dans le copolymère est comprise entre 5% - 70% et la fraction massique de N-arylmaléimide dans le copolymère est comprise entre 5% - 70%, dans lequel le pourcentage massique de la résine fonctionnelle chimiquement stable dans la couche photosensible inférieure est compris entre 75 - 85%.

2. Matériau pour plaque d'impression tel que décrit dans la revendication 1, dans lequel le composé photosensible est choisi dans le groupe constitué du composé 1,2-naphtoquinone-2-diazo-4-sulfonate et du composé 1,2-naphtoquinone-2-diazo-5-sulfonate, dans lequel le matériau de départ d'estérification du composé sulfonate est choisi dans le groupe constitué de, composé de composés polyphénoliques de faible poids moléculaire, de polymères ioniques de condensation pyrogallol-acétone et de résines phénoliques linéaires, dans lequel le matériau de départ d'estérification a un poids moléculaire moyen de 50-20000, avec Mw/Mn de 1,5-20, dans lequel le taux d'hydroxy-estérification est de 10% - 80%, dans lequel la fraction de masse du composé photosensible est de 2% - 20% en poids de la couche photosensible inférieure, dans lequel le pourcentage de masse du composé photosensible est de 30% - 40% en poids de ladite couche photosensible supérieure.

3. Matériau pour plaque d'impression tel que décrit dans la revendication 1 ou 2, dans lequel l'accélérateur de développement est choisi dans le groupe constitué par les composés d'acide carboxylique, d'anhydride d'acide carboxylique, d'acide sulfonique et d'acide phosphorique, dans lequel la quantité d'accélérateur de développement ajoutée à la couche photosensible inférieure est de 3% - 10% du composé de la couche photosensible inférieure, dans lequel la quantité d'accélérateur de développement ajoutée à la couche photosensible supérieure est de 1% - 5% du composé de la couche photosensible supérieure.

4. Matériau pour plaque d'impression tel que décrit dans la revendication 1 ou 2, dans lequel le colorant de fond est choisi dans le groupe constitué par le bleu pur victorien, le bleu brillant basique, le bleu soluble dans l'huile, le violet de cristal, le violet d'éthyle, le violet de méthyle et le bleu de méthylène, dans lequel la quantité en poids du colorant dans la couche photosensible inférieure est de 1 % à 3 %, dans lequel la quantité en poids du colorant dans la couche photosensible supérieure est de 0,1 % à 1 %.

5. Matériau pour plaque d'impression tel que décrit dans la revendication 1, dans lequel la résine filmogène est une résine phénolique linéaire, dans laquelle le poids moléculaire moyen en poids de la résine phénolique linéaire est de 2000 - 20000, dans laquelle le Mw/Mn de la résine phénolique linéaire est de 1,5 - 20, dans lequel la quantité de résine filmogène est de 53,5% - 65% du composé photosensible dans la couche photosensible.

6. Matériau pour plaque d'impression tel que décrit dans la revendication 5, dans lequel la résine phénolique linéaire est polycondensée avec du méthanol et au moins un phénol choisi dans le groupe constitué par le phénol, le m-méthylphénol, le o-méthylphénol, le p-méthylphénol, un mélange de phénol et de m-méthylphénol, et un mélange de phénol et de tert-butylphénol, un mélange comprenant du m-méthylphénol et du p-méthylphénol, du m-,o-méthylphénol, du 2,4-diméthylphénol, du 3,5-diméthylphénol, et un mélange comprenant du m-méthylphénol et du p-méthylphénol modifiés avec du N-phénylmaléimide, respectivement, dans lequel le rapport molaire du mélange comprenant du phénol et du m-méthylphénol est de 3:7-7:3 phénol et m-méthylphénol, dans lequel le rapport molaire du mélange contenant du phénol et du tert-butylphénol est de 3:1-1.5:1 phénol et tert-butylphénol, le rapport molaire m-méthylphénol et p-méthylphénol du mélange contenant du m-méthylphénol et du p-méthylphénol étant de 9:1-5:5, le poids moléculaire moyen en poids de la résine phénolique linéaire étant de 2000-10000 ou 2500-7500, la quantité ajoutée de résine phénolique linéaire étant de 53.5 %-65 % de la masse totale des composés photosensibles dans la couche photosensible supérieure.

7. Matériau pour plaque d'impression tel que décrit dans la revendication 1, dans lequel ledit générateur de photoacide est un composé capable de se décomposer dans la région du proche infrarouge et de l'ultraviolet, ledit générateur de photoacide ayant une plage de détection du spectre lumineux de 350∼420 nm, le pourcentage de poids du générateur de photoacide étant de 0,1 %~0,5 % du composé photosensible de la couche supérieure.

8. Matériau de plaque d'impression tel que décrit dans la revendication 1, 2, 5 ou 6, dans lequel la plaque PS et la plaque CTcP sont exposées et subissent un processus de développement pour former un matériau de plaque d'impression pour la plaque PS à image positive et la plaque d'impression lithographique CTcP, dans lequel le processus de développement comprend une étape de modification et de revêtement de la plaque.
